Europäisches Patentamt

European Patent Office

Office européen des brevets

(19)

(11) EP 0 620 592 B1

(12) **EUROPEAN PATENT SPECIFICATION**

(45) Date of publication and mention
of the grant of the patent:
**09.12.1998 Bulletin 1998/50**

(51) Int Cl.⁶: **H01L 23/467**, H05K 7/20

(21) Application number: **93306980.9**

(22) Date of filing: **03.09.1993**

(54) **Integrated circuit package**

Integrierte Schaltungs-Verpackung

Empaquetage de circuit intégré

(84) Designated Contracting States:
**DE GB**

(30) Priority: **19.03.1993 JP 60005/93**

(43) Date of publication of application:
**19.10.1994 Bulletin 1994/42**

(73) Proprietors:
- **FUJITSU LIMITED**
  **Kawasaki-shi, Kanagawa 211 (JP)**
- **PFU LIMITED**
  **Kahoku-gun Ishikawa 929-11 (JP)**

(72) Inventors:
- **Katsui, Tadashi, c/o FUJITSU LIMITED**
  **Kawasaki-shi, Kanagawa 211 (JP)**
- **Nakata, Katsuhiko, c/o FUJITSU LIMITED**
  **Kawasaki-shi, Kanagawa 211 (JP)**

- **Kitahara, Takashi, c/o PFU LIMITED**
  **Kahoku-gun, Ishikawa 929-11 (JP)**

(74) Representative: **Silverman, Warren et al**
**Haseltine Lake & Co.**
**Imperial House,**
**15-19 Kingsway**
**London WC2B 6UD (GB)**

(56) References cited:
**EP-A- 0 285 779**      **EP-A- 0 614 330**
**WO-A-89/00751**      **WO-A-94/04013**

- **IBM TECHNICAL DISCLOSURE BULLETIN.,**
  **vol.34, no.7B, December 1991, NEW YORK US**
  **pages 321 - 322 'Thin heat pipe for cooling**
  **components on printed circuit boards'**

## Description

This invention relates generally to an integrated circuit package in which an integrated circuit chip is enclosed in a package body in an airtight manner, and more particularly to improvements in the heat radiation characteristics of such an integrated circuit package.

In recent years, portable electronic apparatus such as lap-top personal computers, have appeared on the market. Electronic apparatus of this type require electronics which are miniaturized and have a high reliability. In order to achieve a high performance thereof, it is necessary to use one or more integrated circuit chips. Such integrated circuit chips generate a great amount of heat and therefore integrated circuit packages having high heat radiation properties are demanded.

Conventionally, the heat radiation properties of an integrated circuit package are improved by closely contacting the integrated circuit package with a separate heat sink. However, heat resistance arises from the contact between the integrated circuit package and the heat sink and there is a limitation to the improvement in heat radiation properties of the integrated circuit package that can be made.

EP-A-0614330 which forms the state of the art according to Article 54(3) EPC, discloses an integrated circuit package in which an integrated circuit chip is enclosed within a package body. Adhered to the package body is a heat sink with fins for radiating heat produced by the integrated circuit chip.

Accordingly, it is desirable to provide an integrated circuit package which has superior heat radiation properties.

According to the present invention, there is provided an integrated circuit package comprising:

a package body;
an integrated circuit chip enclosed airtightly within the package body; and
a lead provided at a lower portion of the package body for connecting said integrated circuit chip to an external circuit;
the package body having, at an upper portion thereof, a heat radiation region, comprising heat radiation fins integral with the package body, and an air blowing region in which means for blowing air for cooling the package body, is disposed, a ventilation flue being formed between the heat radiation region and the air blowing region.

Preferably, the means for blowing air comprises a fan assembly which includes a motor having a rotary shaft extending in a direction perpendicular to the plane of the package body, fan blades connected to the rotary shaft, and a driver circuit section for driving the motor.

The integrated circuit package may further comprise a cover secured to the package body so as to close the upper portion thereof, the cover having an opening which communicates with the ventilation flue.

The fan assembly may be secured to the package body or, alternatively, may be secured to the cover.

Preferably, the cover has an annular projection which surrounds the fan blades and functions to increase the difference in static pressure between the opening of the cover and the ventilation flue.

In one embodiment, the fan blades are arranged so that, when they are rotated, air flows from the opening of the cover to the heat radiation region of the package body through the ventilation flue. In another embodiment, the fan blades are arranged so that, when they are rotated, air flows from the heat radiation region of the package body to the opening of the cover through the ventilation flue.

Preferably, the centre of the fan assembly is offset from the centre of heat generation of the package body. This is so that the higher air blowing capacity at the circumferential region of the fan assembly is located above the centre of heat generation of the package body.

In one embodiment, a hollow portion is provided in the package body between the upper portion thereof and the integrated circuit chip, the hollow portion being filled with a liquid or having a heat pipe embedded therein.

The package body may be formed from a ceramic material or alternatively may have a two-layer structure comprising a ceramic body adhered to a metal body, the heat radiation fins being integral with, and the integrated circuit chip being securely mounted to, the metal body.

For a better understanding of the invention, and to show how the same may be carried into effect, reference will now be made, by way of example only, to the accompanying drawings, in which:

Fig. 1 is a schematic side view showing the basic construction of an integrated circuit package in accordance with the present invention;
Fig. 2 is a schematic side view of a prior art integrated circuit package;
Fig. 3 is an equivalent circuit diagram of heat radiation from the device of Fig. 2;
Fig. 4 is an exploded perspective view of an integrated circuit package of a first embodiment of the present invention;
Fig. 5 is a sectional view along the line A-A of Fig 4;
Fig. 6 is a sectional view of an integrated circuit package of a second embodiment of the present invention;
Fig. 7 is a sectional view of an integrated circuit package of a third embodiment of the present invention; and
Fig. 8 is a partial sectional view of an integrated circuit package of a fourth embodiment of the present invention.

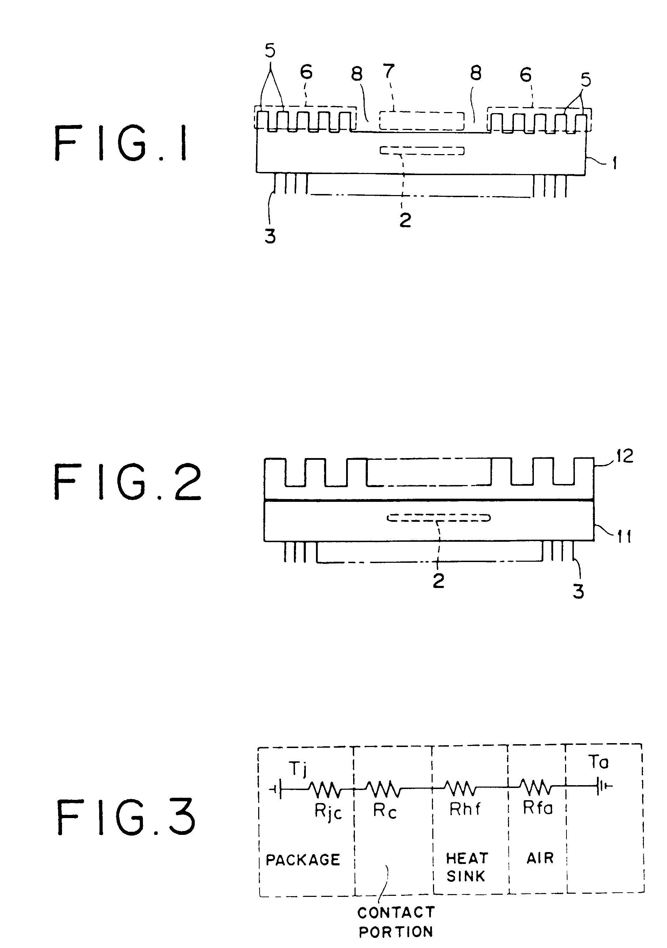

Referring to Fig. 1, an integrated circuit package in accordance with the present invention comprises a package body 1, an integrated circuit chip 2 enclosed airtightly in the package body 1, a lead 3 provided on a lower portion of the package body 1 for connecting the integrated circuit chip 2 to an external circuit, and air blowing means for cooling the package body 1 by forced air cooling. The package body 1 has, in an upper portion thereof, a heat radiation region 6 of a series of fins 5, an air blowing region 7 in which the air blowing means is disposed, and a ventilation flue 8 formed between the heat radiation region 6 and the air blowing region 7.

By way of contrast, referring to Fig. 2, an integrated circuit package of the prior art comprises a package body 11, an integrated circuit chip 2 enclosed airtightly in the package body 11, and a lead 3 provided on a lower portion of the package body 1 for connecting the integrated circuit chip 2 to an external circuit. The upper face of the integrated circuit package is adhered to the lower face of a heat sink 12. In certain circumstances, the heat sink 12 has means for forced air cooling, such as a fan.

Fig. 3 is an equivalent circuit diagram of heat radiation of the integrated circuit package of Fig. 2. Tj denotes the junction temperature (°C) of the integrated circuit chip 2, Rjc heat resistance (°C/W) from the junction of the integrated circuit chip 2 with the surface of the package body 11, Rc heat resistance (°C/W) at the contact between the package body 11 and the heat sink 12, Rhf heat resistance (°C/W) of the heat sink 12, Rfa heat resistance (°C/W) between the heat sink and the air, and Ta an ambient temperature (°C).

In this instance, if the amount (W) of heat generated by the integrated circuit chip 2 is represented by P, then the junction temperature Tj of the integrated circuit chip 2 is represented by the following equation:

$$Tj = P(Rjc + Rc + Rhf + Rfa) + Ta$$

Accordingly, if the junction temperature of the integrated circuit chip 2, when the ambient temperature is equal, is compared between the present invention and the prior art of Fig. 2, it can be seen that the prior art example is higher by a temperature provided by the product of the heat resistance at the contact portion and the amount of heat generated (Rc·P). The heat resistance Rc at the contact portion is generally 0.3 to 0.5 °C/W or so, and when the heat generated by the integrated circuit chip is 20 W, the junction temperature is higher in the prior art example by 6 to 10 °C. While it has been conventional practice to use heat conductive grease or a special bonding agent at the contact between the package body and the heat sink, there is a limitation to the reduction of the heat resistance at the contact between them that can be achieved. Meanwhile, it is said that the reliability of an integrated circuit chip is reduced to one half each time the junction temperature rises by 10 °C.

Accordingly, to provide the heat radiation region 6 on the package body 1 itself, in accordance with the present invention, can be effective to lower the junction temperature to enhance the reliability of the integrated circuit chip. Further, since the air blowing region 7 is provided at the upper portion of the package body 1 and the fins 5 etc in the heat radiation region 6 are cooled by forced air cooling by way of the ventilation flue 8 by the air blowing means disposed in the air blowing region 7, effective heat radiation for the integrated circuit chip 2 becomes possible, and the heat radiation properties of the integrated circuit can be improved remarkably.

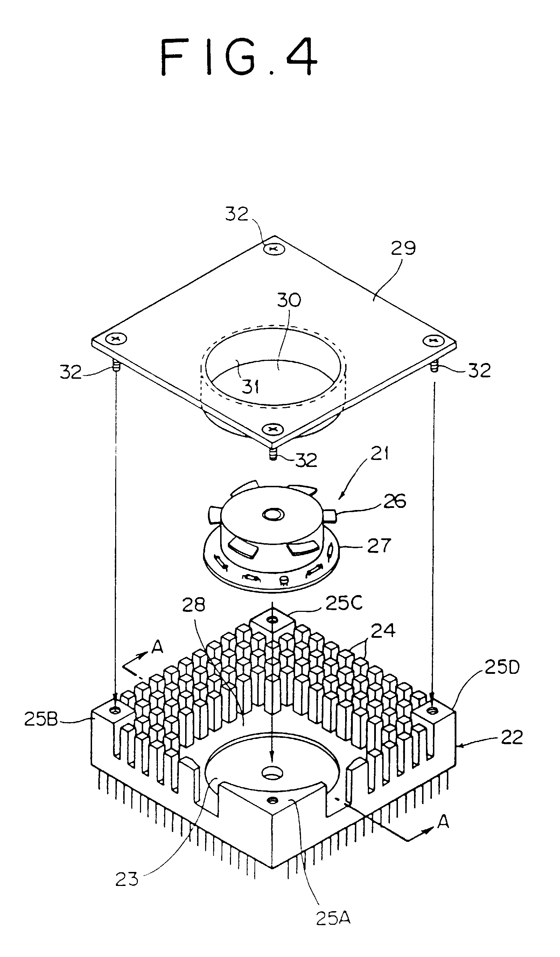

Fig. 4 is an exploded perspective view of an integrated circuit package of a first embodiment of the present invention. In this embodiment, a fan assembly 21 as air blowing means is secured to a mounting portion 23 on the upper portion of a package body 22 to form an air blowing region. The package body 22 is formed in a substantially square shape (as viewed in plan) and has a plurality of upright, pin-like heat radiation fins 24 surrounding the mounting portion 23, and support posts 25A, 25B, 25C and 25D provided at the four corner portions thereof. The fan assembly 21 comprises a motor (not shown) having a rotary shaft extending on a direction perpendicular to the plane of the package body 22, a number of fan blades 26 connected to the rotary shaft, and a driver circuit section 27 for driving the motor (further details of the fan assembly are described in connection with the fourth embodiment). A ventilation flue 28 is formed between the fan assembly 21 on the mounting portion 23 (air blowing region) of the package body 22 and the heat radiation fins 24 (heat radiation region). In this embodiment, the upper portion of the package body 22 is closed by a cover 29 in order to effect efficient blowing of air by the fan assembly 21. The cover 29 is a plate-formed member having substantially the same shape as the shape of the package body 22 (as viewed in plan) and has an opening 30 which communicates with the ventilation flue 28. The cover 29 also has an annular projection 31 which surrounds fan blades 26 leaving a small gap therebetween. The annular projection 31 limits the ventilation flue 28 so that the static pressure difference between the opening 30 and the ventilation flue 28 can be great. The cover 29 is secured at the four corner portions thereof to the support posts 25A, 25B, 25C and 25D of the package body 22 by means of screws 32 or alternative securing means.

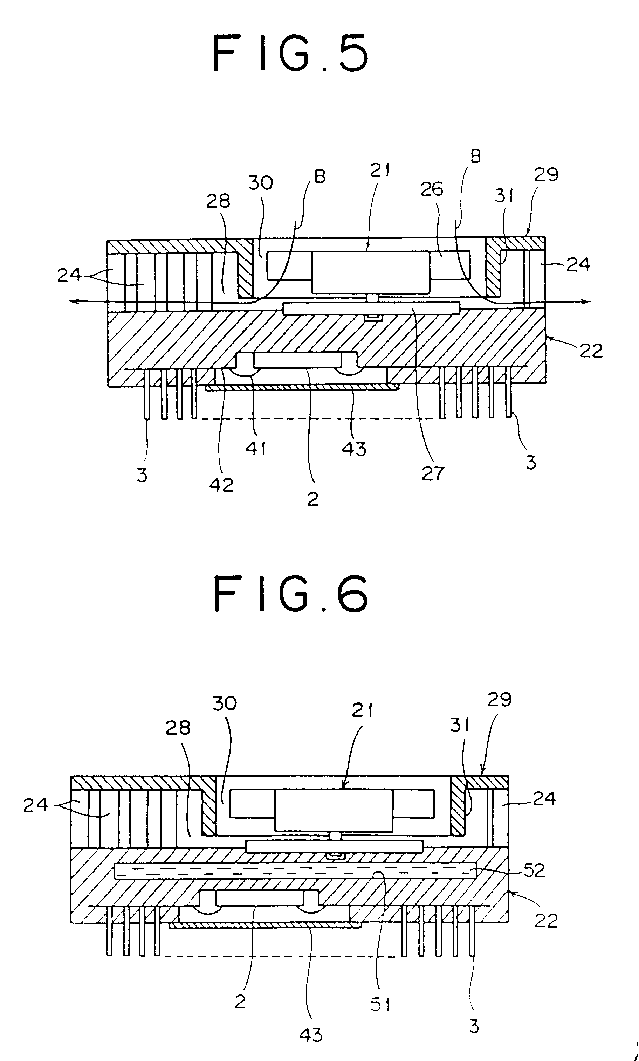

Referring now to Fig. 5, the package body 22 is formed from a ceramic body such as alumina, the fins 24 and so forth being moulded integrally upon sintering of the ceramic body. The integrated circuit chip 2 is securely mounted in a recessed portion of the rear face of the package body 22 and is connected to the leads 3 by way of bonding wires 41 and conductor patterns 42. A lid 43 is provided on the rear face of the package body 22 so that the integrated circuit chip 2 is enclosed in an airtight manner.

If power is supplied to the fan assembly 21 by way of leads (not shown) to rotate the fan blades 26 in a predetermined direction, then air flows in the direction indicated by arrow B by virtue a comparatively great static pressure difference between the outside of the package and the ventilation flue 28 which is caused by the annular projection 31. Accordingly, heat is radiated effectively from the heat radiation fins 24 by such circulation of air.

In the example shown, air flows from the opening 30 through the ventilation flue 28 and then through the heat radiation fins 24 to side portions of the package body 22. However, the inclination angle of the fan blades 26 may be reversed or the direction of rotation of the fan assembly 21 may be reversed so that air flows in the direction opposite to the direction of arrow B. In this embodiment, because the upper portion of the package body 22 is covered by the cover 29 and the annular projection 31 increases the static pressure difference between the outside of the package and the ventilation flue 28, even when the fan assembly 21 is small in size and low in power consumption, a sufficient heat radiation effect can be obtained.

In this first embodiment, the mounting portion 23 of the package body 22 which serves as an accommodation space for the fan assembly 21 is offset in the direction of support post 25A. Two faces of the support post 25A are elongated in the directions of the support posts 25B and 25D respectively (see Fig. 4). The reason why the centre of the fan assembly 21 is offset from the centre of heat generation of the package body 22 (see the integrated circuit chip 2 of Fig. 5) is that the air blowing capacity of the fan assembly 21 is higher at the circumferential region thereof than at the central region thereof. Thus the location where the air blowing capacity is high and the centre of heat generation of the package body 22 substantially coincide with each other. Consequently, heat which is emitted directly from the integrated circuit chip 2 to the upper face of the package body 22 but not to the heat radiation fins 24 can be absorbed by the circulating air. Furthermore, because the position of the fan assembly 21 is offset from the centre of heat generation, any rise in the internal temperature of the fan assembly 21 is restricted, and the reliability of the fan assembly 21 is enhanced. It is to be noted that the reason why the wall of the support port 25A is elongated is that it allows circulation of air to the heat radiation fins 24 to be performed equally.

Fig. 6 is a sectional view of an integrated circuit package of a second embodiment of the present invention. This second embodiment is characterized, in contrast with the embodiment of Figs. 4 and 5, in that a hollow portion 51 is provided in the package body 22 just above the integrated circuit chip 2 and is filled with a liquid 52. The heat resistance of the package body 22 is reduced by the convection action of the liquid. In short, heat generated by the integrated circuit chip 2 is more liable to be transmitted to heat radiation fins 24, and the heat radiation effect can be further enhanced.

A heat pipe may be embedded in the hollow portion 51 in place of the liquid 52. The heat pipe is constructed, for example, by decompressing the inside of an enclosed metal pipe having a capillary substance lined on an inner wall thereof and enclosing a small amount of liquid inside the enclosed metal pipe. By using such a heat pipe, the heat resistance of the package body 22 can be reduced so that heat transmission from the integrated circuit package 2 to the heat radiation fins 24 can be performed effectively.

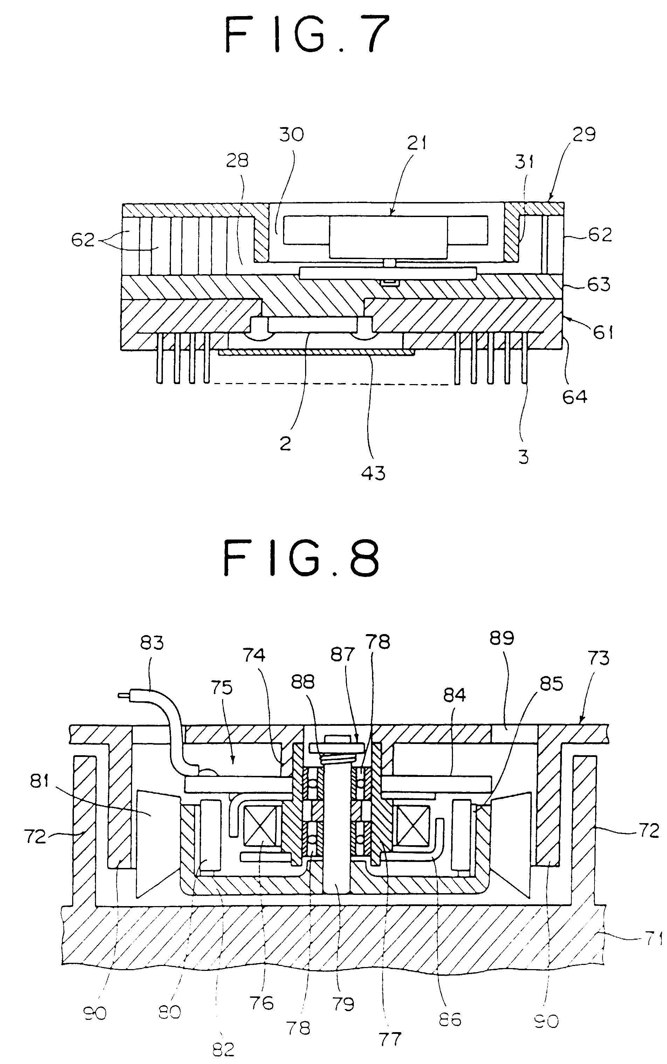

Fig. 7 is a sectional view of an integrated circuit package of a third embodiment of the present invention. This third embodiment is characterized, in contrast with the embodiment of Figs. 4 and 5, in that a package body 61 has a two-layer structure comprising a ceramic body 62 and a metal body 63. The package body 61 is constructed by adhering to a ceramic body 64 having leads 3 provided on a lower portion thereof a metal body 63 having heat radiation fins 62 and support posts (not shown) integrally on the upper portion thereof and having a convex portion on the lower portion thereof to which an integrated circuit chip 2 can be securely mounted. The metal body 63 may be of, for example, aluminum or copper which have high heat conductivities. Because the heat conductivity of a metal body is generally higher than that of a ceramic body, heat transmission from the integrated circuit chip 2 to the heat radiation fins 62 can be further enhanced by securely mounting the integrated circuit chip 2 on the metal body 63.

Fig. 8 is a partial sectional view of an integrated circuit package of a fourth embodiment of the present invention. While, in the embodiments described above, the fan assembly is secured to the package body, in this fourth embodiment, the fan assembly is secured to the cover so that heat from an integrated circuit chip may not be transmitted readily to the fan assembly. Referring to Fig. 8, reference numeral 71 denotes a package body, 72 a heat radiation fin integral with the package body 71, and 73 a cover for closing the upper portion of the package body 71. A fan mounting portion 74 is formed on the rear face of the cover 73, and a fan assembly 75 is secured thereto. The fan assembly 75 comprises a stator 77 press fitted in and/or secured to the fan mounting portion 74 and having a coil 76 provided on an outer peripheral portion thereof, a shaft 79 provided in the centre of the stator 77 by way of a bearing 78, a rotor 82 secured to the shaft 79 and having magnets 80 and fan blades 81 secured to an inner circumferential wall and an outer circumferential wall thereof, respectively, and a printed circuit board 84 to which a lead 83 is connected. A motor driver circuit (not shown) is mounted on the printed circuit board 84. It is to be noted that, in Fig. 8, reference numeral 85 denotes a ring yoke, 86 a yoke, 87 a cut washer mounted on the shaft 79, and 88 a spring for biasing the shaft 79 upwardly. Further, reference numeral 89 denotes an opening for air circulation provided in the cover 73, and 90 an annular projection for assuring a static pressure difference. A plurality of openings 89 is provided along a locus of rotation of the propeller blades 81.

According to this embodiment, because the fan assembly 75 as air blowing means is secured to the cover 73, heat generated from the integrated circuit chip is less liable to be transmitted to the fan assembly 75, when compared to the case in which the fan assembly is secured to the package body as in the first to third embodiments. Therefore, the reliability of the fan assembly 75 can be enhanced and the life thereof can be extended. Furthermore, because the package body does not require mechanical strength for holding the fan assembly, when the hollow portion 51 is formed in the package body 22 (as in the embodiment of Fig. 6), a reduction in the thickness of the package body can be achieved.

As can be seen, the present invention provides an integrated circuit package which has superior heat radiation properties.

## Claims

1. An integrated circuit package comprising:

   a package body (1;22;61;71);
   an integrated circuit chip (2) enclosed airtightly within the package body (1;22;61;71) ; and
   a lead (2) provided at a lower portion of the package body (1;22;61;71) for connecting said integrated circuit chip (2) to an external circuit; the package body (1;22;61;71) having, at an upper portion thereof, a heat radiation region (6),

   comprising heat radiation fins (5;24;62;72) integral with the package body (1;22;61;71), and an air blowing region (7) in which means (21;75) for blowing air for cooling the package body (1;22;61;71) is disposed, a ventilation flue (8;28) being formed between the heat radiation region (6) and the air blowing region (7).

2. An integrated circuit package as claimed in claim 1, wherein the means for blowing air comprises a fan assembly (21;75) which includes a motor having a rotary shaft extending in a direction perpendicular to the plane of the package body (1;22;61;71), fan blades (26;81) connected to the rotary shaft, and a driver circuit section (27;84) for driving the motor.

3. An integrated circuit package as claimed in claim 1 or claim 2, further comprising a cover (29;73) secured to the package body (22;61;71) so as to close the upper portion thereof, the cover (29;73) having an opening (30;89) which communicates with the ventilation flue (28).

4. An integrated circuit package as claimed in claim 2 or claim 3, wherein the fan assembly (21) is secured to the package body (22;61).

5. An integrated circuit package as claimed in claim 3 when appended to claim 2, wherein the fan assembly (75) is secured to the cover (73).

6. An integrated circuit package as claimed in claim 3, 4 or 5 when appended to claim 2, wherein the cover (29;73) has an annular projection (31;90) which surrounds the fan blades (26;81) and functions to increase the difference in static pressure between the opening (30;89) of the cover (29;73) and the ventilation flue (28).

7. An integrated circuit package as claimed in any one of claims 3 to 6 when appended to claim 2, wherein the fan blades (26;81) are arranged so that, when they are rotated, air flows from the opening (30;89) of the cover (29;73) to the heat radiation region (7) of the package body (22;61;71) through the ventilation flue (28).

8. An integrated circuit package as claimed in any one of claims 3 to 6 when appended to claim 2, wherein the fan blades (26;81) are arranged so that, when they are rotated, air flows from the heat radiation region (7) of the package body (22;61;71) to the opening (30;89) of the cover (29;73) through the ventilation flue (28).

9. An integrated circuit package as claimed in any one of claims 2 to 8, wherein the centre of the fan assembly (21;75) is offset from the centre of heat generation of the package body (22;61;71).

10. An integrated circuit package as claimed in any preceding claim, wherein a hollow portion (51) is provided in the package body (22) between the upper portion thereof and the integrated circuit chip (2), the hollow portion (51) being filled with a liquid (52) or having a heat pipe embedded therein.

11. An integrated circuit package as claimed in any preceding claim, wherein the package body (1;22;61; 71) is formed from a ceramic material.

12. An integrated circuit package as claimed in any one of claims 1 to 10, wherein the package body (61) has a two-layer structure comprising a ceramic body (62) adhered to a metal body (63), the heat radiation fins (62) being integral with, and the integrated circuit chip (2) being securely mounted to, the metal body (63).

## Patentansprüche

1. Packung mit integrierter Schaltung, die umfaßt:

   einen Packungskörper (1; 22; 61; 71);

einen Chip mit integrierter Schaltung (2), der innerhalb des Packungskörpers (1; 22; 61; 71) luftdicht eingekapselt ist; und

einen Anschluß (3), der an einem unteren Abschnitt des Packungskörpers (1; 22; 61; 71) vorgesehen ist, zum Verbinden des Chips mit integrierter Schaltung (2) mit einer externen Schaltung;

welcher Packungskörper (1; 22; 61; 71) an seinem oberen Abschnitt eine Wärmeabstrahlungszone (6) hat, die Wärmeabstrahlungsrippen (5; 24; 62; 72) umfaßt, die mit dem Packungskörper (1; 22; 61; 71) integral sind, und eine Luftgebläsezone (7), in der ein Mittel (21; 75) zum Blasen von Luft zum Kühlen des Packungskörpers (1; 22; 61; 71) angeordnet ist, wobei zwischen der Wärmeabstrahlungszone (6) und der Luftgebläsezone (7) ein Ventilationskanal (8; 28) gebildet ist.

2. Packung mit integrierter Schaltung nach Anspruch 1, bei der das Mittel zum Blasen von Luft eine Ventilatorbaugruppe (21; 75) umfaßt, die einen Motor enthält, der einen Rotationsschaft hat, der sich in einer Richtung erstreckt, die zu der Ebene des Packungskörpers (1; 22; 61; 71) rechtwinklig ist, Ventilatorblätter (26; 81), die mit dem Rotationsschaft verbunden sind, und eine Treiberschaltungssektion (27; 84) zum Antreiben des Motors.

3. Packung mit integrierter Schaltung nach Anspruch 1 oder Anspruch 2, ferner mit einer Abdeckung (29; 73), die an dem Packungskörper (22; 61; 71) angebracht ist, um dessen oberen Abschnitt zu verschließen, welche Abdeckung (29; 73) eine Öffnung (30; 89) hat, die mit dem Ventilationskanal (28) in Verbindung steht.

4. Packung mit integrierter Schaltung nach Anspruch 2 oder Anspruch 3, bei der die Ventilatorbaugruppe (21) an dem Packungskörper (22; 61) angebracht ist.

5. Packung mit integrierter Schaltung nach Anspruch 3 in Verbindung mit Anspruch 2, bei der die Ventilatorbaugruppe (75) an der Abdeckung (73) angebracht ist.

6. Packung mit integrierter Schaltung nach Anspruch 3, 4 oder 5 in Verbindung mit Anspruch 2, bei der die Abdekkung (29; 73) einen ringförmigen Vorsprung (31; 90) hat, der die Ventilatorblätter (26; 81) umgibt und dazu dient, die Differenz des statischen Drucks zwischen der Öffnung (30; 89) der Abdekkung (29; 73) und dem Ventilationskanal (28) zu erhöhen.

7. Packung mit integrierter Schaltung nach irgendeinem der Ansprüche 3 bis 6 in Verbindung mit Anspruch 2, bei der die Ventilatorblätter (26; 81) so angeordnet sind, daß dann, wenn sie rotiert werden, Luft von der Öffnung (30; 89) der Abdeckung (29; 73) zu der Wärmeabstrahlungszone (7) des Packungskörpers (22; 61; 71) durch den Ventilationskanal (28) strömt.

8. Packung mit integrierter Schaltung nach irgendeinem der Ansprüche 3 bis 6 in Verbindung mit Anspruch 2, bei der die Ventilatorblätter (26; 81) so angeordnet sind, daß dann, wenn sie rotiert werden, Luft von der Wärmeabstrahlungszone (7) des Packungskörpers (22; 61; 71) zu der Öffnung (30; 89) der Abdeckung (29; 73) durch den Ventilationskanal (28) strömt.

9. Packung mit integrierter Schaltung nach irgendeinem der Ansprüche 2 bis 8, bei der das Zentrum der Ventilatorbaugruppe (21; 75) von dem Wärmeerzeugungszentrum des Packungskörpers (22; 61; 71) versetzt ist.

10. Packung mit integrierter Schaltung nach irgendeinem vorhergehenden Anspruch, bei der ein hohler Abschnitt (51) in dem Packungskörper (22) zwischen dessen oberem Abschnitt und dem Chip mit integrierter Schaltung (2) vorgesehen ist, welcher hohle Abschnitt (51) mit einer Flüssigkeit (52) gefüllt ist oder in dem eine Wärmeröhre eingebettet ist.

11. Packung mit integrierter Schaltung nach irgendeinem vorhergehenden Anspruch, bei der der Packungskörper (1; 22; 61; 71) aus einem keramischen Material gebildet ist.

12. Packung mit integrierter Schaltung nach irgendeinem der Ansprüche 1 bis 10, bei der der Packungskörper (61) eine zweischichtige Struktur hat, die einen keramischen Körper (64) umfaßt, der an einen Metallkörper (63) geklebt ist, wobei die Wärmeabstrahlungsrippen (62) mit dem Metallkörper (63) integral sind und der Chip mit integrierter Schaltung (2) fest an ihn montiert ist.

**Revendications**

1. Boîtier pour circuit intégré comprenant :

   un corps de boîtier (1 ; 22 ; 61 ; 71) ;
   une puce (2) de circuit intégré enfermée de façon étanche à l'intérieur du corps de boîtier (1 ; 22 ; 61 ; 71) ; et
   un conducteur (2) disposé à la partie inférieure dudit corps de boîtier (1 ; 22 ; 61 ; 71) destiné à connecter ladite puce (2) de circuit intégré à un circuit externe ;

le corps de boîtier (1 ; 22 ; 61 ; 71) ayant à sa partie supérieure, une région (6) de rayonnement de la chaleur, comprenant des ailettes (5 ; 24 ; 62 ; 72) de rayonnement de chaleur d'un seul tenant avec le corps de boîtier (1 ; 22 ; 61 ; 71), et une région (7) de soufflage d'air dans laquelle est disposé un moyen (21 ; 75) destiné à souffler de l'air pour refroidir le corps de boîtier (1 ; 22 ; 61 ; 71), un conduit (8 ; 28) de ventilation étant formé entre la région (6) de rayonnement de chaleur et la région (7) de soufflage d'air.

2. Boîtier pour circuit intégré selon la revendication 1, dans lequel le moyen destiné à souffler de l'air comprend un ensemble ventilateur (21 ; 75) qui comporte un moteur ayant un arbre tournant s'étendant dans une direction perpendiculaire au plan du corps de boîtier (1 ; 22 ; 61 ; 71), des pales de ventilateur (26 ; 81) liées à l'arbre tournant, et une section formant circuit d'attaque (27 ; 84) destinée à attaquer le moteur.

3. Boîtier pour circuit intégré selon la revendication 1 ou la revendication 2, comprenant en outre un couvercle (29 ; 73) fixé au corps de boîtier (22 ; 61 ; 71) de façon à clore sa partie supérieure, le couvercle (29 ; 73) comportant une ouverture (30 ; 89) qui communique avec le conduit (28) de ventilation.

4. Boîtier pour circuit intégré selon la revendication 2 ou la revendication 3, dans lequel l'ensemble ventilateur (21) est fixé au corps de boîtier (22 ; 61).

5. Boîtier pour circuit intégré selon la revendication 3 lorsqu'elle dépend de la revendication 2, dans lequel l'ensemble ventilateur (75) est fixé au couvercle (73).

6. Boîtier pour circuit intégré selon la revendication 3, 4 ou 5 lorsqu'elle dépend de la revendication 2, dans lequel le couvercle (29 ; 73) comporte une saillie annulaire (31 ; 90) qui entoure les pales de ventilateur (26 ; 81) et agit pour augmenter la différence de pression statique entre l'ouverture (30 ; 89) du couvercle (29 ; 73) et le conduit (28) de ventilation.

7. Boîtier pour circuit intégré selon l'une quelconque des revendications 3 à 6 lorsqu'elle dépend de la revendication 2, dans lequel les pales de ventilateur (26 ; 81) sont agencées de façon telle que, lorsqu'elles tournent, de l'air s'écoule, par le conduit (28) de ventilation, depuis l'ouverture (30 ; 89) du couvercle (29 ; 73) jusqu'à la région (7) de rayonnement de chaleur du corps de boîtier (22 ; 61 ; 71).

8. Boîtier pour circuit intégré selon l'une quelconque des revendications 3 à 6 lorsqu'elle dépend de la revendication 2, dans lequel les pales de ventilateur (26 ; 81) sont agencées de façon telle que, lorsqu'elles tournent, de l'air s'écoule, par le conduit (28) de ventilation, depuis la région (7) de rayonnement de chaleur du corps de boîtier (22 ; 61 ; 71) jusqu'à l'ouverture (30 ; 89) du couvercle (29 ; 73).

9. Boîtier pour circuit intégré selon l'une quelconque des revendications 2 à 8, dans lequel le centre de l'ensemble ventilateur (21 ; 75) est décalé par rapport au centre de production de chaleur du corps de boîtier (22 ; 61 ; 71).

10. Boîtier pour circuit intégré selon l'une quelconque des revendications précédentes, dans lequel une partie creuse (51) est ménagée dans le corps de boîtier (22) entre sa partie supérieure et la puce (2) de circuit intégré, la partie creuse (51) étant remplie d'un liquide (52) et comportant un tuyau de chaleur noyé à l'intérieur.

11. Boîtier pour circuit intégré selon l'une quelconque des revendications précédentes, dans lequel le boîtier (1 ; 22 ; 61 ; 71) est formé à partir d'une matière à base de céramique.

12. Boîtier pour circuit intégré selon l'une quelconque des revendications 1 à 10, dans lequel le corps de boîtier (61) présente une structure à deux couches comprenant un corps (62) en céramique collé à un corps (63) en métal, les ailettes (62) de rayonnement de chaleur étant d'un seul tenant avec, et la puce (2) de circuit intégré étant montée à demeure sur, le corps (63) en métal.

FIG.1

FIG.2

FIG.3

# F I G . 4

# F I G. 5

# F I G. 6

# FIG.7

# FIG.8